# EUROPEAN PATENT SPECIFICATION

(11) **EP 2 966 491 B1**
(45) Date of publication and mention of the grant of the patent: **02.02.2022**
(21) Application number: 14186386.0
(22) Date of filing: 25.09.2014
(51) Int. Cl.: G02B 19/00, G01J 1/42, G01J 1/04

(54) **Lens assembly, optoelectronic package and method of producing an optoelectronic package with lens assembly**
Linsenanordnung, optoelektronisches Gehäuse und Verfahren zur Herstellung eines optoelektronischen Wafer-Gehäuses mit der Linsenanordnung
Ensemble de lentilles, emballage optoélectronique et procédé de production d'un emballage optoélectronique avec ensemble de lentilles

(30) Priority: 09.07.2014 US 201462022529 P
(43) Date of publication of application: 13.01.2016
(73) Proprietor: ams AG, 8141 Premstätten (AT)
(72) Inventor: Mehrl, David, Plano, TX Texas 75025 (US); Etschmaier, Harald, 8010 Graz (AT)
(74) Representative: Epping - Hermann - Fischer

(56) References cited:
- EP-A1- 2 701 209
- WO-A1-96/31742
- FR-A1- 2 887 627
- US-A1- 2012 037 205
- US-A1- 2012 037 793
- US-A1- 2014 145 069

## Description

Ambient light sensors (ALS) are commonly used to control the brightness of displays, both for user comfort and for the purpose of conserving battery power in handheld devices. Customers would like the ALS to respond to light hitting the sensor aperture from a wide range of angles. At the same time, many optical sensors are prone to error when light impacts the sensor surface at large angles.

US 2007/0176081 A1 discloses a lens assembly for use with an ambient light sensor. The lens is arranged in an aperture of a housing to direct incident light over an area of the light sensor that is greater than the area of the housing aperture.

US 8,319,764 B2 discloses an ambient light sensor used for a dynamical adjustment of display brightness to compensate for changes in ambient light. A wave guide is provided for improving angular response.

US 8,378,577 B2 discloses a liquid crystal display including an electronically controlled backlight module and an ambient light sensor, which comprises a photosensitive unit and an optical sheet with a plurality of V-shaped micro structures.

US 2014/0103816 A1 discloses an arrangement of a touchscreen glass for increasing the reception of an ambient light sensor of a mobile phone. A light uniformizing film is disposed between the touchscreen glass and an optical sensor.

FR 2 887 627 A1 discloses an apparatus for the detection of infrared radiation. An IR detector is covered with a cold shield, which has a cross section in the shape of an arc of an ellipse and comprises a diaphragm opposite the detector. The diaphragm may be circular, and the base of the cold shield may be cylindrical.

WO 96/31742 A1 discloses collimating totally internally reflecting lens devices employing fluorescent light sources. A body means in the shape of a cover or dome has multiple facets or elements each comprising an entry face, an exit face and an internal reflection face reflecting incident radiation toward the exit face. Corresponding points on the facets define a concave surface, which may be parabolic. The total internal reflection occurs inside the body means, but not within the volume that is encased by the body means.

US 2012/0037205 A1 discloses a solar cell concentrator. Photovoltaic devices are covered by an array of parallel strands forming a lens assembly with dome shape tip.

US 2012/0037793 A1 discloses lenses formed by a plurality of lens sections, which yield a dome shape.

US 2014/0145069 A1 discloses packaged light detector semiconductor devices comprising a light detector die and a molding material. A non-imaging optical concentrator, which collects and concentrates light for the active photosensor region, is formed by a recess in the molding material. The recess of the optical concentrator grows wider with increasing distance from the active photosensor region.

EP 2701209 A1 relates to a reflection-type photoelectric sensor including an optical system having a configuration in which a light beam for detection is projected and a reflected light beam of the detecting light beam is received. In a light receiving lens, a light beam from a direction different from the direction expected as the optical path of the receivable reflected light beam may be guided to the light receiving element by the reflection of the light beam from a recess. Further, a lens holder is provided comprising an aperture.

It is an object of the present invention to disclose a compact optoelectronic package providing a wide field of view. It is a further object to disclose a method of producing the optoelectronic package.

This object is achieved with the lens assembly according to claim 1, with the optoelectronic package according to claim 10, and with the method of producing an optoelectronic package according to claim 11. Embodiments and variants derive from the dependent claims.

The lens assembly comprises a lens, which has an upper surface, a lateral surface surrounding the lens, and a bottom surface. An optoelectronic component is arranged at or near the bottom surface, and an aperture is arranged at the upper surface, so that the lens is arranged between the optoelectronic component and the aperture. If a direction pointing from the bottom surface towards the upper surface is designated as vertical direction, and one of the directions that are orthogonal to the vertical direction is specified as the relevant lateral direction, widths of the lens are defined in this lateral direction by the lateral surface. These widths decrease in the vertical direction from a maximal width at or near the bottom surface to a non-vanishing minimal width at the upper surface.

An embodiment of the lens assembly further comprises an opaque encasement arranged at or near at least a portion of the lateral surface.

In a further embodiment of the lens assembly, an encasement is arranged adjacent to at least a portion of the lateral surface, and the encasement has an index of refraction that is smaller than the index of refraction of the lens.

In a further embodiment of the lens assembly, the entire lens is tapered towards the aperture. This means that the widths of the lens that are measured in the same lateral direction decrease from a maximal width at the bottom surface of the lens to a non-vanishing minimal width at the upper surface of the lens, and this is true for any specified lateral direction.

In a further embodiment of the lens assembly, the lens is not axially symmetrical.

A further embodiment of the lens assembly comprises a dimple in the upper surface of the lens.

In a further embodiment of the lens assembly, areas of the lateral surface of the lens join at boundaries where the inclination of the lateral surface with respect to the bottom surface is discontinuous.

In a further embodiment of the lens assembly, the optoelectronic component is an ambient light sensor.

In a further embodiment of the lens assembly, an array of lenses is provided for the optoelectronic component, the lens forming part of the array. The lenses may all be tapered and may in particular have the same shape. An array of tapered lenses may especially be favourable if the optoelectronic component comprises an array of optoelectronic devices like photosensors, for example.

The optoelectronic package including such a lens assembly comprises a carrier including electric interconnections. The optoelectronic component may be mounted on the carrier or integrated in the carrier.

In an embodiment of the optoelectronic package, the carrier is a semiconductor substrate or wafer, and the optoelectronic component is integrated in the semiconductor substrate or wafer.

In a further embodiment of the optoelectronic package, the carrier is a printed circuit board, and the optoelectronic component is mounted on the printed circuit board.

The method of producing an optoelectronic package comprises providing a carrier including electric interconnections, arranging an optoelectronic component in or on the carrier, forming a lens or an array of lenses and an encasement of the lens or of the array on or above the optoelectronic component, and forming an aperture of the encasement opposite the optoelectronic component. The aperture may especially be formed in a cap layer, which is mounted to the encasement. The encasement and the lens or the array are formed from different materials by moulding.

In a variant, a coating is applied to the lens after moulding. Then the encasement is formed on the carrier adjacent to the coating by moulding, and the coating is subsequently removed, thus forming a void.

The following is a detailed description of examples of the lens assembly and the method of producing an optoelectronic package in conjunction with the appended figures.
- Figure 1: is a cross section of an optoelectronic package including a lens assembly.
- Figure 2: is a cross section of a further optoelectronic package including a lens assembly.
- Figure 3: is a cross section of a further optoelectronic package including a tapered lens with convex sidewall.
- Figure 4: is a cross section of a further optoelectronic package including a tapered lens with concave sidewall.
- Figure 5: is a cross section of a further lens assembly including a lens having different bevels.
- Figure 6: is a top view of an optoelectronic package including a lens assembly.
- Figure 7: is a top view of a further optoelectronic package including a lens assembly.
- Figure 8: is a top view of an optoelectronic package including a lens assembly forming an array.
- Figure 9: is a top view of a further optoelectronic package including a lens assembly forming an array.
- Figure 10: is a perspective view of a lens assembly including a moulded lens.
- Figure 11: is a perspective view according to Figure 10 with an encasement arranged for mounting.
- Figure 12: is a perspective view according to Figure 10 after the lens has been embedded in a coating.
- Figure 13: is a perspective view of the shape of an encasement as it is moulded on the carrier.
- Figure 14: is a perspective view of an optoelectronic package comprising the lens assembly and the encasement.

The dimensions shown in the figures are not drawn to scale, and some aspect ratios may have been exaggerated for the sake of clarity.

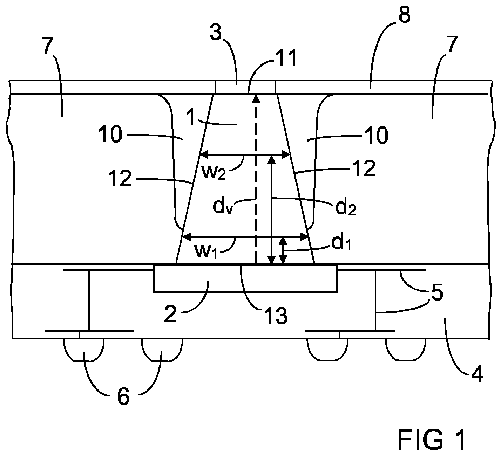

Figure 1 is a cross section of an optoelectronic package including a lens assembly. A lens 1 formed from a transparent material or a lens-shaped region 1, which is limited by boundary surfaces, is arranged above an optoelectronic component 2, which is a photodetector, for instance, or a device emitting radiation. The optoelectronic component 2 may especially be provided as an ambient light sensor, but other applications may be suitable as well. A surface of the lens or lens-shaped region 1 facing the optoelectronic component 2, which will here be designated as the bottom surface 13, may be contiguous with a surface of the optoelectronic component 2. The lens or lens-shaped region 1 may instead be arranged at a distance from the optoelectronic component 2, which may be embedded in transparent material filling the interspace between the optoelectronic component 2 and the lens or lens-shaped region 1. At least one further optical component like an interference filter, for instance, may optionally be arranged at or on the optoelectronic component 2. Figure 1 shows a schematic representation of the optoelectronic component 2, which is meant to include these options. An aperture 3 is arranged at the upper surface 11 of the lens or lens-shaped region 1 opposite the bottom surface 13. The lens or lens-shaped region 1 is thus arranged between the optoelectronic component 2 and the aperture 3.

The optoelectronic package comprising the lens assembly includes a carrier 4 with electric interconnections 5, which may be provided with bump contacts 6 or the like for external electric connection. The carrier 4 may be a semiconductor substrate or wafer, and the optoelectronic component 2 may be integrated in the semiconductor substrate or wafer. In this case the interconnections 5 may form a wiring, which may also be provided for further integrated components like CMOS components, and may in particular include through-substrate vias. The interconnections 5 and integrated components may be produced in a standard CMOS process, for instance. The lens or lens-shaped region 1 and the aperture 3 may thus be integrated at wafer level, which enables minimizing the footprint and assembly costs. The carrier 4 may instead be any other carrier suitable for optoelectronic packages, like a printed circuit board, for instance. The optoelectronic component 2 may be mounted on the printed circuit board using conventional semiconductor technology.

An encasement 7 is provided for the lens or lens-shaped region 1. In a further embodiment, the encasement 7 is opaque. The encasement can also be transparent, comprising an index of refraction that allows total internal reflection in the lens or lens-shaped region 1. If the lens assembly comprises a lens 1 formed from a transparent material, the encasement 7 may be in contact with the entire lateral surface 12 of the lens 1, or the encasement 7 may only be contiguous with a portion of the lateral surface 12 of the lens 1, as shown in Figure 1. In the main embodiment, the encasement 7 is arranged at a distance from the lens 1. If the encasement 7 does not cover the entire lateral surface 12 of the lens 1, a void 10, which may be filled with air, for instance, is left between the encasement 7 and the lens 1. In particular, if the encasement 7 is opaque, such a void 10 of small index of refraction enables the occurrence of total internal reflection in the lens 1. The lens 1 and/or the encasement 7 are formed by moulding.

A lens-shaped region 1 may be present instead of a lens 1. The lens-shaped region 1, which may be filled with air, for instance, can be defined by the encasement 7, which in this case provides the lateral surface 12 of the lens-shaped region 1. Furthermore, any other suitable surface reflecting the radiation or providing a discontinuity of the index of refraction may be provided between regions of the package. In particular, the lateral surface 12 of the lens-shaped region 1 may be provided with a reflective coating, which is not shown in Figure 1. Surface layers that reflect the incident radiation, like aluminium coatings on plastic or glass, which may be used as the material of the encasement 7, for instance, may also be applied to fold the path of radiation.

The aperture 3 is formed by the encasement 7, or by a cap layer 8 with a window provided to form the aperture 3 mounted to the lens assembly. The cap layer 8 may be opaque or semitransparent to shield stray light, and its transparency may especially depend on the wavelength. In particular, the cap layer 8 may be formed by a metal shield, for instance.

A direction pointing from the bottom surface 13 towards the upper surface 11 will here be designated as vertical direction dᵥ, and one of the directions that are orthogonal to the vertical direction dᵥ is specified as the relevant lateral direction. Widths w₁, w₂ of the lens or lens-shaped region 1 are defined in the specified lateral direction by the lateral surface 12. Figure 1 shows a first width w₁ at a first distance d₁ from the bottom surface 13 and a smaller second width w₂ at a larger second distance d₂ from the bottom surface 13. The widths w₁, w₂ thus defined decrease in the vertical direction dᵥ from a maximal width at the bottom surface 13 to a non-vanishing minimal width at the upper surface 11. In the embodiment shown in Figure 1, the lens or lens-shaped region 1 especially comprises the shape of a truncated cone. Other suitable shapes will be described in the following in conjunction with various embodiments.

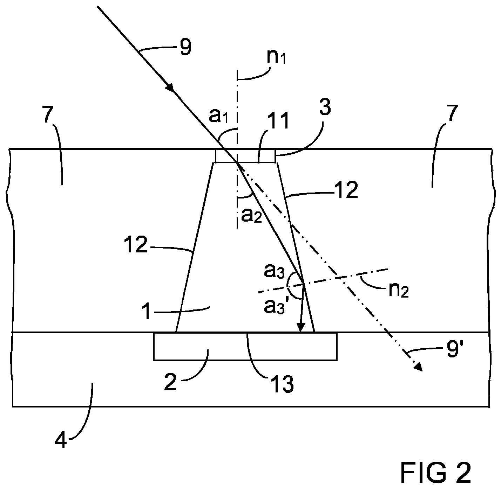

Figure 2 is a cross section of a further optoelectronic package including a lens assembly. Components of the optoelectronic package according to Figure 2 that correspond to similar components of the optoelectronic package according to Figure 1 are designated with the same reference numerals. The aperture 3 of the lens assembly shown in Figure 2 is formed by the encasement 7, which covers the entire lateral surface 12 of the lens or lens-shaped region 1 in this embodiment. The lens or lens-shaped region 1 can be used to direct incident radiation from a wide field of view onto the optoelectronic component 2. In the following description, the lens assembly will be assumed to include a lens 1 formed from a transparent material having an index of refraction larger than the index of refraction of air (≈1).

Figure 2 shows a ray 9 incident on the upper surface 11 of the lens 1 through the aperture 3 at an angle a₁ of incidence with respect to the normal n₁ to the upper surface 11. The angle a₂ of refraction differs from the angle a₁ of incidence according to Snell's law, taking account of the index of refraction of the lens 1. The direction of the ray 9 thus deviates within the lens 1 from the direction of a virtual straight ray 9'. The refracted ray 9 reaches the lateral surface 12 of the lens 1 at a further angle a₃ of incidence with respect to the normal n₂ to the lateral surface 12. If the index of refraction of the encasement 7 is smaller than the index of refraction of the lens 1 and the further angle a₃ of incidence is sufficiently large, the ray 9 is reflected by total internal reflection at the lateral surface 12 of the lens 1. The angle a₃' of reflection is the same as the further angle a₃ of incidence, and the ray 9 is thus ultimately directed onto the optoelectronic component 2. The original inclination of the ray 9 with respect to the normal n₁ is thus decreased, and the field of view of the optoelectronic component 2 is enlarged. The direction of the ray 9 may be reversed, if the optoelectronic component 2 is a light-emitting device, for example.

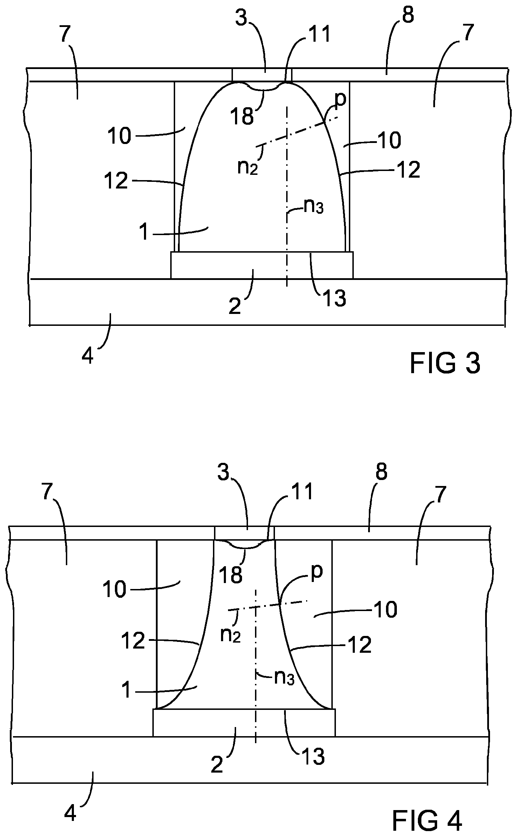

Figure 3 is a cross section of a further optoelectronic package including a lens assembly. Components of the optoelectronic package according to Figure 3 that correspond to similar components of the optoelectronic package according to Figures 1 and 2 are designated with the same reference numerals. The lens assembly of the embodiment according to Figure 3 comprises a tapered lens 1 with a convex cross section of the lateral surface 12. The lateral surface 12 is bulged in such a manner that its inclination with respect to the bottom surface 13 decreases in the vertical direction with increasing distance from the bottom surface 13. This means that, if the cross section shown in Figure 3 is at a position where the lateral surface 12 is orthogonal to the plane of the drawing, so that the normal n₂ to the lateral surface 12 always lies within the cross section, the acute angle between the normal n₃ to the bottom surface 13 and the normal n₂ to the lateral surface 12 at a given point p of the lateral surface 12 decreases with increasing distance of the point p from the bottom surface 13. The shape of the lateral surface 12 may be selected from a variety of shapes, and its curvature can be adapted to requirements of individual applications. The curvature may be elliptical, parabolical, hyperbolical or exponential, for instance, or corresponding to any other either analytically defined or irregular geometrical shapes.

The upper surface 11 and the portion of the lateral surface 12 that is in the vicinity of the upper surface 11 may show a pronounced deviation from the general shape of the lateral surface 12. In particular, the top of the lens 1, where radiation enters or leaves the lens 1, may be spherical, ellipsoidal or the like, irrespective of the shape of the lower portion of the lateral surface 12.

The height of the lens 1 and its tapering may be restricted by prescribed maximal dimensions of the package and the physical width of the active area, which may cause deviations from the desired angular field of view. Such deviations can at least partially be corrected by a dimple 18 formed in the upper surface 11 of the lens 1. Such a dimple 18 is suitable for manufacture by moulding, which may be preferred in view of efficiency and low costs. In particular, the size of the dimple 18 and its curvature comply with requirements specified by mould manufacturers. Instead of the dimple 18, an opaque or partially opaque (i. e. translucent) ink dot placed on the tip of the lens 1 may be applied as an alternative for attenuating the radiation in the vicinity of the axis of the lens 1.

Figure 4 is a cross section of a further optoelectronic package including a lens assembly. Components of the optoelectronic package according to Figure 4 that correspond to similar components of the optoelectronic package according to Figure 3 are designated with the same reference numerals. The lens assembly of the embodiment according to Figure 4 comprises a tapered lens 1 with a concave cross section of the lateral surface 12. The lateral surface 12 is curved in such a manner that its inclination with respect to the bottom surface 13 increases in the vertical direction with increasing distance from the bottom surface 13. This means that, if the cross section shown in Figure 4 is at a position where the lateral surface 12 is orthogonal to the plane of the drawing, so that the normal n₂ to the lateral surface 12 always lies within the cross section, the acute angle between the normal n₃ to the bottom surface 13 and the normal n₂ to the lateral surface 12 at a given point p of the lateral surface 12 increases with increasing distance of the point p from the bottom surface 13.

In the embodiment according to Figure 4, as in the embodiment according to Figure 3, the shape of the lateral surface 12 may be selected from a variety of shapes, and its curvature can be adapted to requirements of individual applications. The curvature may be elliptical, parabolical, hyperbolical or exponential, for instance, or corresponding to any other either analytically defined or irregular geometrical shapes. In other embodiments of the lens 1, the vertical curvature may be partially convex and partially concave.

In Figures 3 and 4 the curvature of the lateral surface 12 is clearly indicated. But in preferred embodiments of the lens assembly, the vertical curvature of the lens 1 may typically be weaker than shown in the figures, so that the shape of the lateral surface 12 does not deviate significantly from a cone. The top of the lens 1 including the upper surface 11 may deviate from the general shape of the lens 1 and may especially be spherical or ellipsoidal, irrespective of the shape of the lower portion of the lateral surface 12.

If the height of the lens 1 and its tapering is restricted by prescribed requirements, a dimple 18 can be provided in the upper surface 11 of the lens 1 as described above in conjunction with the embodiment according to Figure 3. Such a dimple 18 can also be provided in the upper surface 11 of the lens 1 of any other embodiment, in particular in the upper surface 11 of a lens 1 forming a truncated cone, as in the embodiments according to Figures 1 and 2.

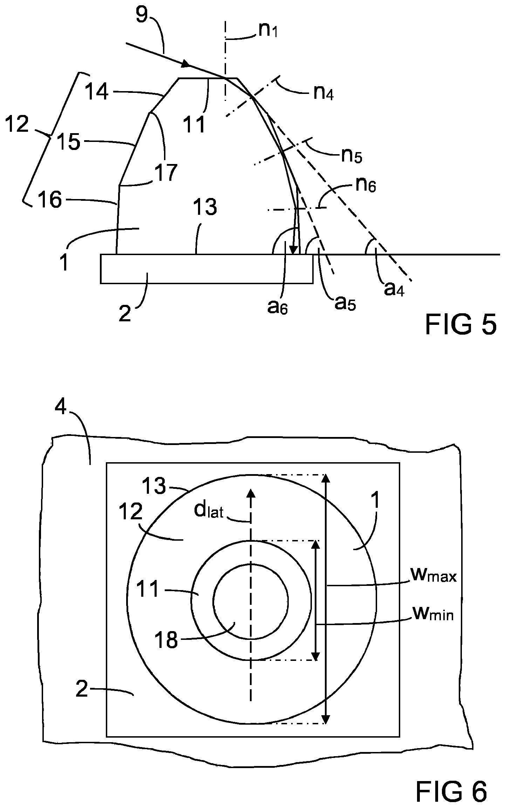

Figure 5 is a cross section of a further lens assembly including a lens having different bevels. The lateral surface 12 is formed by lateral surface areas 14, 15, 16 of different inclinations. These lateral surface areas 14, 15, 16 may have any shape that is compatible with the general tapering of the lens 1, in particular a vertical convex or concave curvature. In Figure 5, by way of example, the lateral surface areas 14, 15, 16 are shown to be truncated cones of different opening angles. The angles a₄, a₅, a₆ of inclination of the lateral surface areas 14, 15, 16 with respect to the bottom surface 13 are shown in Figure 5 by means of broken lines extending the cross sections of the upper lateral surface area 14 and the middle lateral surface area 15. The angle a₄ of inclination of the upper lateral surface area 14 is smaller than the angle a₅ of inclination of the middle lateral surface area 15, and the latter angle a₅ is smaller than the angle a₆ of inclination of the lower lateral surface area 16. The lateral surface areas 14, 15, 16 join at boundaries 17 where the angles a₄, a₅, a₆ of inclination vary discontinuously.

Figure 5 shows how a convex lens 1, especially a lens 1 having different bevels, may be used for the direction of a ray 9 by means of repeated total internal reflection. The incident ray 9 is refracted at the upper surface 11 of the lens 1 and totally internally reflected at the upper lateral surface area 14. As the upper lateral surface area 14 and the middle lateral surface area 15 comprise normals n₄, n₅ that are not parallel to one another, the reflected ray 9 may impinge on the middle lateral surface area 15 and again be reflected by total internal reflection. As the middle lateral surface area 15 and the lower lateral surface area 16 comprise normals n₅, n₆ that are not parallel either, the twice reflected ray 9 may also impinge on the lower lateral surface area 16 and again be reflected by total internal reflection. The total angle of deflection of the ray 9 thus achieved is essentially larger than the angle of deflection in the case of only one total internal reflection. Figure 5 also shows how the succession of different angles a₄, a₅, a₆ of inclination of the lateral surface 12 causes a corresponding succession of angles of incidence sufficiently large for total internal reflection of the ray 9.

Figure 6 is a top view of an optoelectronic package including a lens assembly. The optoelectronic component 2 is arranged on or in the carrier 4, and the lens or lens-shaped region 1 is arranged on or above the optoelectronic component 2. The upper surface 11 of the lens or lens-shaped region 1 is shown to be provided with a dimple 18. In the embodiment shown in Figure 6, the lateral surface 12 of the lens or lens-shaped region 1 is axially symmetrical. The width of the lens or lens-shaped region 1 therefore only depends on the height above the optoelectronic component 2, but not on the lateral direction dₗₐₜ. The width of the lens or lens-shaped region 1 decreases from a maximal width wₘₐₓ at the bottom surface 13 to a non-vanishing minimal width wₘᵢₙ at the upper surface 11.

In this description and in the claims, a width of the lens or lens-shaped region 1 is always meant to be defined by the lateral surface 12 of the lens or lens-shaped region 1. If the upper surface 11 of the lens or lens-shaped region 1 is not flat, the maximal distance from the bottom surface 13 may be reached at the centre of the upper surface 11 or, if a dimple 18 is present, on a circle around the centre of the upper surface 11. In this case a width of the lens or lens-shaped region 1 is not to be measured between points lying within the upper surface 11. Hence the relevant minimal width wₘᵢₙ shown in Figure 6 does not vary if a lateral dimension of the top of the lens or lens-shaped region 1 varies owing to a curvature of the upper surface 11 in the region above the lateral surface 12. In this sense the width of the lens or lens-shaped region 1 is non-vanishing, even if the upper surface 11 may have a central peak. Whereas the lateral width of a conical lens vanishes at the apex, the lateral width of the lens or lens-shaped region 1 used in the lens assembly does not vanish, which makes a substantial difference.

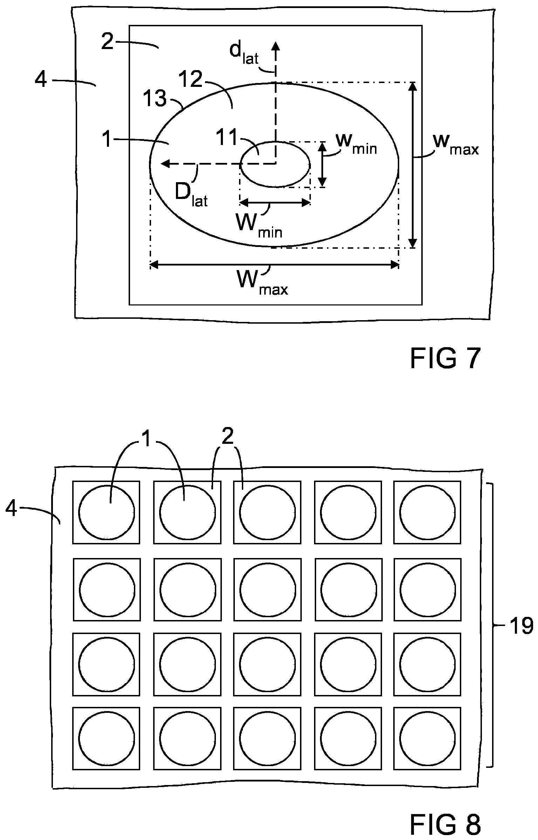

Figure 7 is a top view of a further optoelectronic package including a lens assembly. The components shown in Figure 7 that correspond to components shown in Figure 6 are designated with the same reference numerals. In the embodiment shown in Figure 7, the lens or lens-shaped region 1 is not axially symmetrical. This may be desired if the field of view is not intended to be axially symmetrical either. The lens or lens-shaped region 1 may be a truncated elliptical cone, for example. The lateral surface 12 may instead be convex or concave or composed of surface areas providing discontinuous inclinations as described above. The lateral width measured in any fixed lateral direction decreases in the vertical direction from a maximal width at the bottom surface 13 to a non-vanishing minimal width at the upper surface 11.

In the embodiment according to Figure 7, the bottom surface 13 is an ellipse. In the case of a lens or lens-shaped region 1 forming an elliptical cone, at any fixed distance from the bottom surface 13, there is a lateral direction dₗₐₜ of smallest width of the lens or lens-shaped region 1 and a lateral direction Dₗₐₜ of largest width of the lens or lens-shaped region 1, the directions corresponding to the major and minor axes of the ellipse. The lateral width measured in the lateral direction dₗₐₜ of smallest width of the lens or lens-shaped region 1 decreases from a maximal width wₘₐₓ at the bottom surface 13 to a non-vanishing minimal width wₘᵢₙ at the upper surface 11. In the same way, the lateral width measured in the lateral direction Dₗₐₜ of largest width of the lens or lens-shaped region 1 decreases from a maximal width Wₘₐₓ at the bottom surface 13 to a non-vanishing minimal width Wₘᵢₙ at the upper surface 11.

Figure 8 shows a top view of an embodiment of the lens assembly comprising an array 19 of lenses or lens-shaped regions 1. A plurality of tapered lenses or lens-shaped regions 1 forming an array may thus be employed to cover a large optoelectronic component 2 or an array of optoelectronic components 2, especially if there are constraints on the height of the package. A tapered lens or lens-shaped region 1 can be arranged above each optoelectronic component 2 of an array of optoelectronic components 2, as shown in Figure 8. Instead, groups of optoelectronic components 2 can be provided with one lens or lens-shaped region 1 of the array 19. A plurality of individual apertures 3 forming an array of apertures may be adapted to the upper surfaces 11 of the lenses or lens-shaped regions 1 to prevent radiation from entering the lenses or lens-shaped regions 1 through the lateral surface 12.

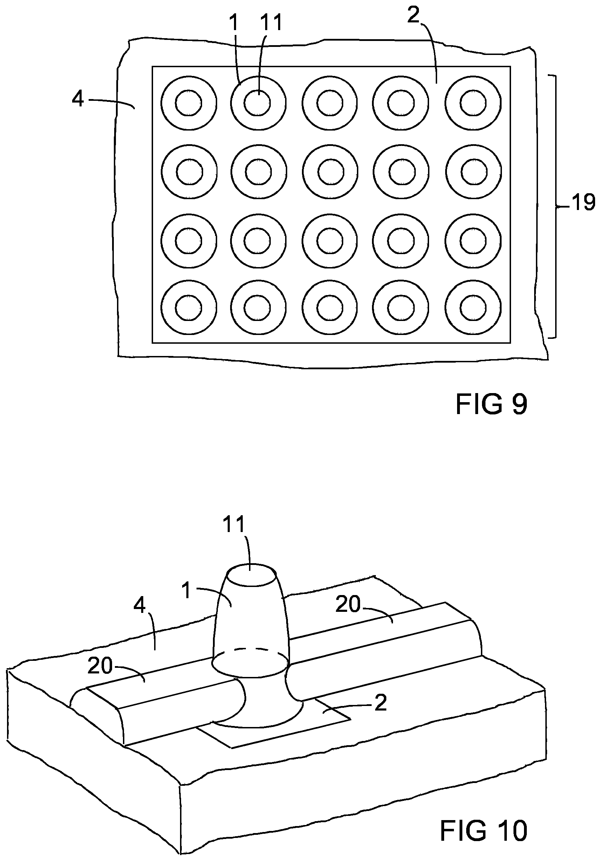

Figure 9 shows a top view of a further embodiment comprising an array 19 of lenses or lens-shaped regions 1. In the embodiment according to Figure 9, the array 19 of lenses or lens-shaped regions 1 is provided for one large optoelectronic component 2. In an array of optoelectronic components 2, each optoelectronic component 2 or some of the optoelectronic components 2 may be provided with an array 19 of lenses or lens-shaped regions 1 as shown in Figure 9. The array 19 of lenses can be provided with a corresponding array of individual apertures 3, in order to prevent radiation from entering the lenses or lens-shaped regions 1 through their lateral surfaces 12.

Figure 10 is a perspective view of a lens assembly including a moulded lens. The lens 1 is mounted on a carrier 4 above the optoelectronic component 2, which may be integrated in the carrier 4, for example. In the embodiment according to Figure 10, a bottom portion of the lens 1 has a concave vertical curvature, while the upper portion has a convex vertical curvature. Instead, a bottom portion of the lens 1 may have the shape of a truncated cone, while the upper portion forms a paraboloid of revolution, for example. Other shapes of the lens 1, especially the shapes shown in Figures 1 to 5, may also be formed by moulding. Figure 10 shows the upper surface 11 of the lens 1 to be flat, but the top of the lens 1 may instead be curved, so that moulding is facilitated. The top of the lens 1 may especially be provided with a dimple as in the embodiments previously described. If the lens 1 is formed by moulding, a mould may be applied directly on the carrier 4, and a mould compound that is intended as the material forming the lens 1 is then filled through a runner or sprue. A sprue ridge 20 may therefore remain at the flank of the moulded lens 1, as shown in Figure 10 by way of example.

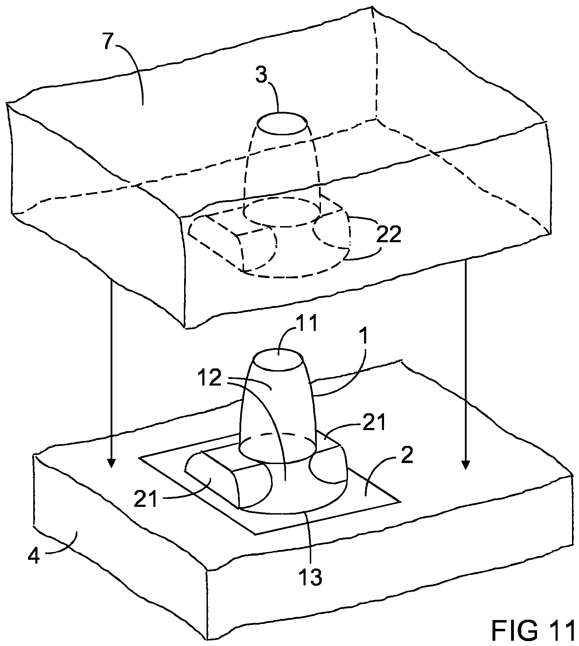

Figure 11 is a perspective view according to Figure 10 after a partial removal of the sprue ridge 20, which may be effected by sawing, for example. A complete removal of the sprue ridge 20 may be preferred, but stubs 21 of the sprue ridge 20 may be left at the lateral surface 12 of the lens 1. An encasement 7 is prepared and arranged above the carrier 4 for mounting, as shown in Figure 11. The encasement 7 is provided with a recess 22 in the shape of the lens 1. Such an encasement 7 can also be formed by moulding, in particular using an opaque material suitable to shield the intended radiation. As indicated in Figure 11 by arrows, the encasement 7 is put over the lens 1 and fastened on the carrier 4 by means of a suitable adhesive, for instance. A cover 8 as shown in Figure 1 may additionally be applied on the encasement 7.

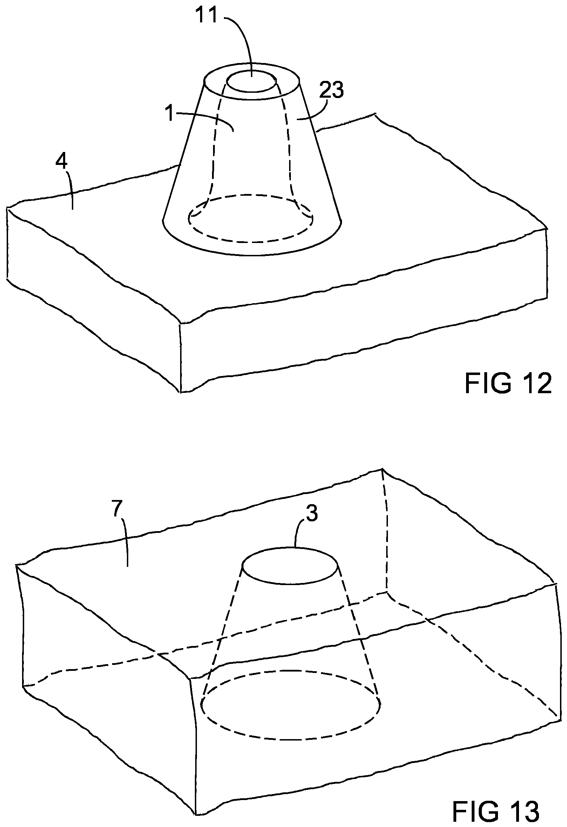

Figure 12 is a perspective view according to Figure 10 for an intermediate product of a variant of the method. The lens 1 has been embedded in a coating 23, which is provided as a sacrificial layer. The coating 23 can be applied by conventional dispensing or moulding, for instance. The lateral surface 12 of the lens 1 is preferably completely covered by the coating 23. Apart from that, the coating 23 may have any appropriate shape. The upper surface 11 may also be covered, or it may be free from the coating 23 as shown in Figure 12. The encasement 7 may subsequently be moulded directly on the carrier 4 and the coating 23, which protects the lens 1. Only the tip of the lens 1 remains exposed, and thus the aperture 3 is formed. An opaque mold compound may be preferred for the encasement 7. The resulting structure is similar to the result of the method previously described, but a glueing step for mounting the encasement 7 is avoided.

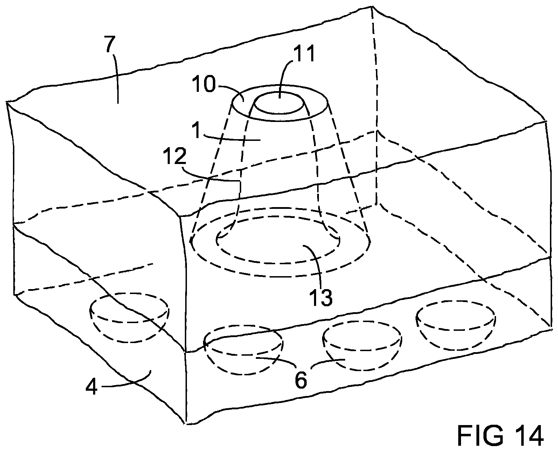

Figure 13 is a perspective view of the shape the encasement 7 takes when it is moulded on the carrier 4 comprising the lens 1 and the coating 23 according to Figure 12. Figure 14 is a perspective view of an optoelectronic package comprising the lens assembly and the encasement 7 for the embodiment according to Figures 12 and 13. If the coating 23 comprises a material that can be removed by a suitable solvent, which does not attack the material of the lens 1, such a solvent may be applied to the exposed top surface of the coating 23, after the encasement 7 has been moulded, in order to remove the coating 23 and to form a void 10 between the lens 1 and the encasement 7. The resulting structure is similar to the embodiments shown in Figures 1, 3 and 4. Bump contacts 6, which may be solder balls, for instance, can be applied on the rear side of the carrier 4 for external electric connections.

Instead of the described method, both the transparent mould compound provided for the lens 1 and the preferably opaque mould compound provided for the encasement 7 may directly be applied onto the carrier 4, without use of a sacrificial layer like the coating 23 described above. Furthermore, by using an appropriate mould for the encasement 7, the lateral surface 12 of the lens 1 can be kept at least partially free from the mould compound of the encasement 7. A structure of the void 10 typically resembling the void 10 shown in the cross section of Figure 1, by way of example, may thus be obtained. An interference filter may favourably be applied to the optoelectronic component 2 to compensate for effects caused by such a void 10 being present at an area of the lateral surface 12 of the lens 1.

The lens assembly may especially be provided by reflective surfaces to fold the path of the radiation, thus allowing the optical system to reside in a compact package, while still presenting a wide field of view. Nested structures multiply folding the light paths by reflection or refraction may also be applied to reduce the required dimensions of the package. Steep surfaces that reflect most of the light using Fresnel reflection, where the light travels from a low index medium (like air, for instance) to a higher index medium (like glass or transparent or semitransparent plastic, for instance) may be particularly favourable for the described purposes. The efficiency of the Fresnel reflection increases as the light strikes the surface at progressively steeper glancing angles.

The accuracy and efficiency of an optoelectronic device is enhanced by the described lens assembly. It provides a large field of view while restricting the angle of view presented to the optoelectronic component. A further benefit for the user will be the small aperture, which will be less visible than in conventional optoelectronic packages. The dimensions, especially the height, of the optoelectronic package using the described lens assembly are substantially reduced compared with conventional packages of ambient light sensors or the like. The use of an opaque mould or a metal shield as a cover eliminates the need for a rubber boot. The method of producing the lens assembly by moulding is appropriate for mass production and reduction of the manufacturing costs.

### List of reference numerals

- 1: lens or lens-shaped region
- 2: optoelectronic component
- 3: aperture
- 4: carrier
- 5: interconnection
- 6: bump contact
- 7: encasement
- 8: cap layer
- 9: ray
- 9': virtual ray
- 10: void
- 11: upper surface
- 12: lateral surface
- 13: bottom surface
- 14: upper lateral surface area
- 15: middle lateral surface area
- 16: lower lateral surface area
- 17: boundary
- 18: dimple
- 19: array of lenses
- 20: sprue ridge
- 21: stub
- 22: recess
- 23: coating
- a₁: angle of incidence
- a₂: angle of refraction
- a₃: further angle of incidence
- a₃': angle of reflection
- a₄: angle of inclination of the upper lateral surface area
- a₅: angle of inclination of the middle lateral surface area
- a₆: angle of inclination of the lower lateral surface area
- d₁: first distance
- d₂: second distance
- dₗₐₜ: lateral direction of smallest widths
- Dₗₐₜ: lateral direction of largest widths
- dᵥ: vertical direction
- n₁: normal to the upper surface
- n₂: normal to the lateral surface
- n₃: normal to the bottom surface
- n₄: normal to the upper lateral surface area
- n₅: normal to the middle lateral surface area
- n₆: normal to the lower lateral surface area
- w₁: first width
- w₂: second width
- wₘₐₓ: smallest maximal width
- Wₘₐₓ: largest maximal width
- wₘᵢₙ: smallest minimal width
- Wₘᵢₙ: largest minimal width

## Claims

1. A lens assembly, comprising:
- a lens (1) formed from a transparent material, which has an upper surface (11), a lateral surface (12) surrounding the lens (1), and a bottom surface (13),
- a lateral direction (dₗₐₜ, Dₗₐₜ), which is orthogonal to a vertical direction (dᵥ) pointing from the bottom surface (13) towards the upper surface (11), widths (w₁, w₂) of the lens (1) that are defined in the lateral direction (dₗₐₜ, Dₗₐₜ) by the lateral surface (12) decreasing in the vertical direction (dᵥ) from a maximal width (Wₘₐₓ, Wₘₐₓ) at or near the bottom surface (13) to a non-vanishing minimal width (wₘᵢₙ, Wₘᵢₙ) at the upper surface (11),
- an optoelectronic component (2) arranged at or near the bottom surface (13),
- an encasement (7) is provided for the lens (1),
- the encasement (7) is arranged at a distance from the lens (1), and
- a void (10) is left between the encasement (7) and the lens (1),
- an aperture (3) is provided at the upper surface (11), the lens (1) being arranged between the optoelectronic component (2) and the aperture (3), wherein the aperture (3) is formed by the encasement (7) or by a cap layer (8), **characterized in that**
- the lens (1) is configured to direct incident radiation from a wide field of view onto the optoelectronic component (2) by total internal reflection at the lateral surface (12) of the lens (1), or to direct emitted radiation from the optoelectronic component (2) in a reversed direction, respectively.

2. The lens assembly of claim 1, further comprising:
the encasement (7) being an opaque encasement (7) arranged at or near at least a portion of the lateral surface (12).

3. The lens assembly of claim 1, further comprising:
an index of refraction of the lens (1), and
the encasement (7) having a smaller index of refraction being arranged adjacent to at least a portion of the lateral surface (12).

4. The lens assembly of one of claims 1 to 3, wherein the entire lens is tapered towards the aperture (3).

5. The lens assembly of one of claims 1 to 4, wherein the lens is not axially symmetrical.

6. The lens assembly of one of claims 1 to 5, further comprising:
a dimple (18) formed in the upper surface (11).

7. The lens assembly of one of claims 1 to 6, wherein areas (14, 15, 16) of the lateral surface (12) of the lens (1) join at boundaries (17) where an inclination (a₄, a₅, a₆) of the lateral surface (12) with respect to the bottom surface (13) is discontinuous.

8. The lens assembly of one of claims 1 to 7, wherein the optoelectronic component (2) is an ambient light sensor.

9. The lens assembly of one of claims 1 to 8, further comprising:
an array (19) of lenses provided for the optoelectronic component (2), the lens (1) forming part of the array (19).

10. An optoelectronic package including a lens assembly of one of claims 1 to 9, comprising:
a carrier (4) including electric interconnections (5), the optoelectronic component (2) being mounted on the carrier (4) or integrated in the carrier (4).

11. A method of producing an optoelectronic package, comprising:
- providing a carrier (4) including electric interconnections (5),
- arranging an optoelectronic component (2) in or on the carrier (4),
- forming a lens (1) or an array (19) of lenses, each lens being as defined in anyone of claims 1, 4-7, and an encasement (7) of the lens (1) or of the array (19) on or above the optoelectronic component (2), the encasement (7) being arranged at a distance from each of the lenses (1, 19), so that a void (10) is left between the encasement (7) and each of the lenses (1, 19), forming the lens (1) or array (19) and the encasement (7) from different materials by moulding, and
- forming an aperture (3) of the encasement (7) opposite the optoelectronic component (2), the aperture (3) being formed by the encasement (7) or by a cap layer (8),
- configuring the lens (1) to direct incident radiation from a wide field of view onto the optoelectronic component (2) by total internal reflection at the lateral surface (12) of the lens (1), or to direct emitted radiation from the optoelectronic component (2) in a reversed direction, respectively.

12. The method of producing an optoelectronic package according to claim 11, further comprising:
forming a dimple (18) in the upper surface (11) of the lens (1) .

13. The method of producing an optoelectronic package according to claim 11, further comprising:
after moulding the lens (1), applying a coating (23), moulding the encasement (7) on the carrier (4) adjacent to the coating (23), and
subsequently removing the coating (23), thus forming the void (10) .

## Patentansprüche

1. Linsenanordnung, aufweisend:
- eine aus einem transparenten Material gebildete Linse (1), die eine obere Fläche (11), eine die Linse (1) umgebende Seitenfläche (12) und eine Bodenfläche (13) aufweist,
- eine seitliche Richtung (dlat, Dlat), die orthogonal zu einer vertikalen Richtung (dv) ist, die von der Bodenfläche (13) zur oberen Fläche (11) zeigt, wobei Breiten (w1, w2) der Linse (1), die in der seitlichen Richtung (dlat, Dlat) durch die Seitenfläche (12) definiert sind, in der vertikalen Richtung (dv) von einer maximalen Breite (wmax, Wmax) an oder nahe der unteren Fläche (13) bis zu einer nicht verschwindenden minimalen Breite (wmin, Wmin) an der oberen Fläche (11) abnehmen,
- ein optoelektronisches Bauelement (2), das an oder in der Nähe der Bodenfläche (13) angeordnet ist,
- eine Ummantelung (7), die für die Linse (1) vorgesehen ist,
- wobei die Ummantelung (7) in einem Abstand von der Linse (1) angeordnet ist, und
- zwischen der Ummantelung (7) und der Linse (1) ein Hohlraum (10) vorhanden ist,
- an der oberen Fläche (11) eine Öffnung (3) vorgesehen ist, wobei die Linse (1) zwischen dem optoelektronischen Bauelement (2) und der Öffnung (3) angeordnet ist, wobei die Öffnung (3) durch die Ummantelung (7) oder durch eine Deckschicht (8) gebildet ist,
**dadurch gekennzeichnet, dass**
- die Linse (1) so ausgelegt ist, dass sie einfallende Strahlung aus einem breiten Sichtfeld durch Totalreflexion an der Seitenfläche (12) der Linse (1) auf das optoelektronische Bauelement (2) lenkt bzw. von dem optoelektronischen Bauelement (2) emittierte Strahlung in eine umgekehrte Richtung lenkt.

2. Linsenanordnung nach Anspruch 1, weiterhin aufweisend:
wobei die Ummantelung (7) eine undurchsichtige Ummantelung (7) ist, die an oder in der Nähe mindestens eines Teils der Seitenfläche (12) angeordnet ist.

3. Linsenanordnung nach Anspruch 1, ferner aufweisend:
einen Brechungsindex der Linse (1), und wobei die Ummantelung (7), die einen kleineren Brechungsindex aufweist, zu mindestens einem Teil der Seitenfläche (12) benachbart angeordnet ist.

4. Linsenanordnung nach einem der Ansprüche 1 bis 3, wobei die gesamte Linse zur Öffnung (3) hin verjüngt ist.

5. Linsenanordnung nach einem der Ansprüche 1 bis 4, wobei die Linse nicht axialsymmetrisch ist.

6. Linsenbaugruppe nach einem der Ansprüche 1 bis 5, ferner aufweisend:
eine Vertiefung (18), die in der oberen Fläche (11) ausgebildet ist.

7. Linsenanordnung nach einem der Ansprüche 1 bis 6, wobei Bereiche (14, 15, 16) der Seitenfläche (12) der Linse (1) an Grenzlinien (17) zusammenlaufen, an denen eine Neigung (a4, a5, a6) der Seitenfläche (12) in Bezug auf die Bodenfläche (13) diskontinuierlich ist.

8. Linsenanordnung nach einem der Ansprüche 1 bis 7, wobei das optoelektronische Bauelement (2) ein Umgebungslichtsensor ist.

9. Linsenanordnung nach einem der Ansprüche 1 bis 8, ferner aufweisend:
Ein Array (19) von Linsen, die für das optoelektronische Bauteil (2) vorgesehen ist, wobei die Linse (1) Teil des Arrays (19) ist.

10. Optoelektronische Baugruppe mit einer Linsenanordnung nach einem der Ansprüche 1 bis 9, aufweisend:
einen Träger (4) mit elektrischen Verbindungen (5), wobei das optoelektronische Bauelement (2) auf dem Träger (4) montiert oder in den Träger (4) integriert ist.

11. Verfahren zur Herstellung einer optoelektronischen Baugruppe, umfassend:
- Bereitstellen eines Trägers (4) mit elektrischen Verbindungen (5),
- Anordnen eines optoelektronischen Bauelements (2) in oder auf dem Träger (4),
- Ausbilden einer Linse (1) oder eines Arrays (19) von Linsen, wobei jede Linse wie in einem der Ansprüche 1, 4-7 definiert ist, und einer Ummantelung (7) der Linse (1) oder des Arrays (19) auf oder über dem optoelektronischen Bauelement (2), wobei die Ummantelung (7) in einem Abstand von jeder der Linsen (1, 19) angeordnet ist, so dass zwischen der Ummantelung (7) und jeder der Linsen (1, 19) ein Hohlraum (10) verbleibt, Ausbilden der Linse (1) oder des Arrays (19) und der Ummantelung (7) aus unterschiedlichen Materialien durch Abformung, und
- Ausbilden einer Öffnung (3) der Ummantelung (7) gegenüber dem optoelektronischen Bauelement (2), wobei die Öffnung (3) durch die Ummantelung (7) oder durch eine Deckschicht (8) gebildet wird,
- Auslegen der Linse (1), um einfallende Strahlung aus einem weiten Sichtfeld auf das optoelektronische Bauelement (2) durch Totalreflexion an der Seitenfläche (12) der Linse (1) zu lenken, bzw. um von dem optoelektronischen Bauelement (2) emittierte Strahlung in eine umgekehrte Richtung zu lenken.

12. Verfahren zur Herstellung einer optoelektronischen Baugruppe nach Anspruch 11, das ferner aufweist:
Ausbilden einer Vertiefung (18) in der oberen Fläche (11) der Linse (1).

13. Verfahren zur Herstellung einer optoelektronischen Baugruppe nach Anspruch 11, das ferner aufweist:
nach dem Formen der Linse (1) Aufbringen einer Beschichtung (23),
Formen der Ummantelung (7) auf dem Träger (4) angrenzend an die Beschichtung (23), und
anschließendes Entfernen der Beschichtung (23), wodurch der Hohlraum (10) gebildet wird.

## Revendications

1. Ensemble de lentilles, comprenant:
- une lentille (1) formée à partir d'un matériau transparent, qui a une surface supérieure (11), une surface latérale (12) entourant la lentille (1), et une surface inférieure (13),
- une direction latérale (dₗₐₜ, Dₗₐₜ), qui est orthogonale à une direction verticale (dᵥ) pointant de la surface inférieure (13) vers la surface supérieure (11), des largeurs (w₁, w₂) de la lentille (1) qui sont définies dans la direction latérale (dₗₐₜ, Dₗₐₜ) par la surface latérale (12) diminuant dans la direction verticale (dᵥ) d'une largeur maximale (wₘₐₓ, Wₘₐₓ) au niveau ou à proximité de la surface inférieure (13) à une largeur minimale (wₘᵢₙ, Wₘᵢₙ) ne disparaissant pas au niveau de la surface supérieure (11),
- un composant optoélectronique (2) arrangé sur ou près de la surface inférieure (13),
- un boîtier (7) est prévu pour la lentille (1),
- le boîtier (7) est arrangé à une certaine distance de la lentille (1), et
- un vide (10) est laissé entre le boîtier (7) et la lentille (1),
- une ouverture (3) est prévue à la surface supérieure (11), la lentille (1) étant arrangée entre le composant optoélectronique (2) et l'ouverture (3), dans lequel l'ouverture (3) est formée par le boîtier (7) ou par une couche de recouvrement (8),
**caractérisé en ce que**
- la lentille (1) est configurée pour diriger un rayonnement incident provenant d'un large champ de vision sur le composant optoélectronique (2) par réflexion interne totale au niveau de la surface latérale (12) de la lentille (1), ou pour diriger un rayonnement émis par le composant optoélectronique (2) dans une direction inversée, respectivement.

2. L'ensemble de lentilles selon la revendication 1, comprenant en outre:
le boîtier (7) étant un boîtier opaque (7) arrangé sur ou près d'au moins une partie de la surface latérale (12).

3. L'ensemble de lentilles selon la revendication 1, comprenant en outre:
un indice de réfraction de la lentille (1), et
le boîtier (7) ayant un indice de réfraction plus petit et étant arrangé de manière adjacente à au moins une partie de la surface latérale (12).

4. L'ensemble de lentilles selon l'une des revendications 1 à 3, dans lequel la lentille entière est effilée vers l'ouverture (3).

5. L'ensemble de lentilles selon l'une des revendications 1 à 4, dans lequel la lentille (1) n'est pas axialement symétrique.

6. L'ensemble de lentilles selon l'une des revendications 1 à 5, comprenant en outre:
une fossette (18) formée dans la surface supérieure (11).

7. L'ensemble de lentilles selon l'une des revendications 1 à 6, dans lequel des zones (14, 15, 16) de la surface latérale (12) de la lentille (1) se rejoignent au niveau de limites (17) où une inclinaison (a₄, a₅, a₆) de la surface latérale (12) par rapport à la surface inférieure (13) est discontinue.

8. L'ensemble de lentilles de l'une des revendications 1 à 7, dans lequel le composant optoélectronique (2) est un capteur de lumière ambiante.

9. L'ensemble de lentilles de l'une des revendications 1 à 8, comprenant en outre:
un réseau (19) de lentilles prévues pour le composant optoélectronique (2), la lentille (1) faisant partie du réseau (19).

10. Un package optoélectronique comprenant un ensemble de lentilles selon l'une des revendications 1 à 9, comprenant:
un support (4) comprenant des interconnexions électriques (5), le composant optoélectronique (2) étant monté sur le support (4) ou intégré dans le support (4).

11. Un procédé de production d'un package optoélectronique, comprenant:
- la fourniture d'un support (4) comprenant des interconnexions électriques (5),
- l'arrangement d'un composant optoélectronique (2) dans ou sur le support (4),
- la formation d'une lentille (1) ou d'un réseau (19) de lentilles, chaque lentille (1) étant telle que définie dans l'une quelconque des revendications 1, 4-7, et un boîtier (7) de la lentille (1) ou du réseau (19) sur ou au-dessus du composant optoélectronique (2), le boîtier (7) étant disposé à une distance de chacune des lentilles (1, 19), de sorte qu'un vide (10) est laissé entre le boîtier (7) et chacune des lentilles (1, 19), former la lentille (1) ou le réseau (19) et le boîtier (7) à partir de matériaux différents par moulage, et
- la formation d'une ouverture (3) du boîtier (7) en face du composant optoélectronique (2), l'ouverture (3) étant formée par le boîtier (7) ou par une couche de recouvrement (8),
- configurer la lentille (1) pour diriger le rayonnement incident d'un large champ de vision sur le composant optoélectronique (2) par réflexion interne totale sur la face latérale (12) de la lentille, ou pour diriger le rayonnement émis par le composant optoélectronique (2) dans une direction inversée, respectivement.

12. Le procédé de production d'un package optoélectronique selon la revendication 11, comprenant en outre:
la formation d'une fossette (18) dans la surface supérieure (11) de la lentille (1).

13. Le procédé de production d'un package optoélectronique selon la revendication 11, comprenant en outre:
après le moulage de la lentille (1), l'application d'un revêtement (23),
le moulage du boîtier (7) sur le support (4) adjacent au revêtement (23), et
l'élimination ultérieure du revêtement (23), formant ainsi le vide (10).
